# EUROPÄISCHE PATENTSCHRIFT

(11) **EP 0 490 896 B1**
(45) Veröffentlichungstag und Bekanntmachung des Hinweises auf die Patenterteilung: **30.11.1994**
(21) Anmeldenummer: 90906913.0
(22) Anmeldetag: 25.05.1990
(51) Int. Cl.: H01L 25/11

(54) **GLEICHRICHTEREINRICHTUNG FÜR DREHSTROMGENERATOREN VON FAHRZEUGEN**
RECTIFIER FOR THREE-PHASE CURRENT GENERATORS IN VEHICLES
REDRESSEUR POUR GENERATEURS DE COURANT TRIPHASE DANS DES VEHICULES

(30) Priorität: 05.09.1989 DE 3929427
(43) Veröffentlichungstag der Anmeldung: 24.06.1992
(73) Patentinhaber: ROBERT BOSCH GMBH, 70442 Stuttgart (DE)
(72) Erfinder: KOPLIN, Karl-Heinz, D-7141 Schwieberdingen (DE); RENNER, Stefan, D-7251 Weissach-Flacht (DE); PFLUEGER, Gerhard, D-7145 Markgröningen (DE); FASTERDING, Henning, D-7145 Markgröningen (DE)
(86) Internationale Anmeldenummer: DE9000382
(87) Internationale Veröffentlichungsnummer: WO9103836

(56) Entgegenhaltungen:
- EP-A- 0 088 910
- WO-A-89/02161
- FR-A- 2 369 731
- GB-A- 1 452 157
- US-A- 4 554 574
- US-A- 4 606 000

## Beschreibung

### Stand der Technik

Die Erfindung geht aus von einer Gleichrichtereinrichtung für Drehstromgeneratoren von Fahrzeugen nach dem Oberbegriff des Hauptanspruchs.

Bei einer aus dem deutschen Gebrauchsmuster G 87 11417 bekannten Gleichrichtereinrichtung dieser Art ist ein Anschlußbolzen für den nach DIN mit B+ bezeichneten Anschluß der Gleichrichtereinrichtung in die äußere der beiden zueinander mit Abstand parallel liegenden Kühlplatten der Gleichrichterdioden eingesetzt, indem er mit einer Rändelung in ein entsprechendes Loch der äußeren Kühlplatte eingepreßt ist und an der Ringschulter des Schraubenkopfes an der Rückseite der Kühlplatte anliegt. Der Gewindebolzen ist ferner zur Sicherung mit einer Mutter an der Kühlplatte festgeschraubt. Die Gleichrichtereinrichtung wird an der sogenannten B-Seite des Drehstromgenerators montiert. Nach dem Einbau des Generators ins Fahrzeug wird am freien Ende des Gewindebolzens ein Anschlußkabel für den Plus-Pol des Fahrzeugs-Akkumulators festgeschraubt.

Nachteilig bei derartigen Lösungen ist, daß bei starken Schüttelbeanspruchungen sowie bei starken Anzugs-Drehmomenten und Biegemomenten an dem Anschluß Kräfte wirksam werden können, durch die das Kühlblech deformiert oder die Befestigung an der Rändelung gelockert wird.

Ein derartiger Auschluß wird auch im FR-A-2 369 731 offenbart.

Mit der vorliegenden Lösung wird angestrebt, die an dem Anschlußbolzen wirksamen Kräfte derart zu verteilen, daß er den geforderten Beanspruchungen standhält.

### Vorteile der Erindung

Die erfindungsgemäße Gleichrichtereinrichtung mit den kennzeichnenden Merkmalen des Hauptanspruchs hat den Vorteil, daß die Kräfte der Schüttelbeanspruchung, der Anzugs-Drehmomente und der Biegemomente in beide Kühlbleche eingeleitet werden. Dabei werden insbesondere die Biegekräfte unwirksam, da sie parallel zu den Blechebenen in die beiden Kühlbleche eingeleitet werden. Eine Deformierung des Plus-Kühlbleches ist dadurch nicht mehr möglich. Ein weiterer Vorteil besteht darin, daß diese Lösung ohne zusätzliche Bauteile zu realisieren ist.

Durch die in den Unteransprüchen aufgeführten Maßnahmen ergeben sich vorteilhafte Weiterbildungen und Verbesserungen der im Hauptanspruch angegebenen Merkmale.

Besonders vorteilhaft in der Herstellung ist es, wenn die Isolierstoffbuchse für den hinteren Zapfen des Gewindebolzens des Plus-Anschlusses der Gleichrichtereinrichtung an der Leiterplatte angeformt ist, die sich zwischen den beiden Kühlplatten befindet.

Zur Vermeidung bzw. Herabsetzung von Anzugs-Drehmomenten an der Befestigungsstelle des Gewindebolzens an der Plus-Kühlplatte wird in besonders geeigneter Weise eine Metallbuchse in eine Schutzkappe aus Isolierstoff schwimmend und verdrehsicher gelagert, wobei der Gewindebolzen durch die Metallbuchse nach außen hindurchragt. Zweckmäßigerweise ist dabei die Metallbuchse mit einer Sechseck-Außenkontur versehen und in einer Sechseck-Aufnahme der Schutzkappe verdrehsicher geführt. Die Metallbuchse ist ferner in vorteilhafter Weise gegen ein Herausfallen aus der Sechseck-Aufnahme der Schutzkappe gesichert, in dem mehrere radiale Vorsprünge jeweils an den Endbereichen der Sechseck-Aufnahme angeformt sind.

### Zeichnung

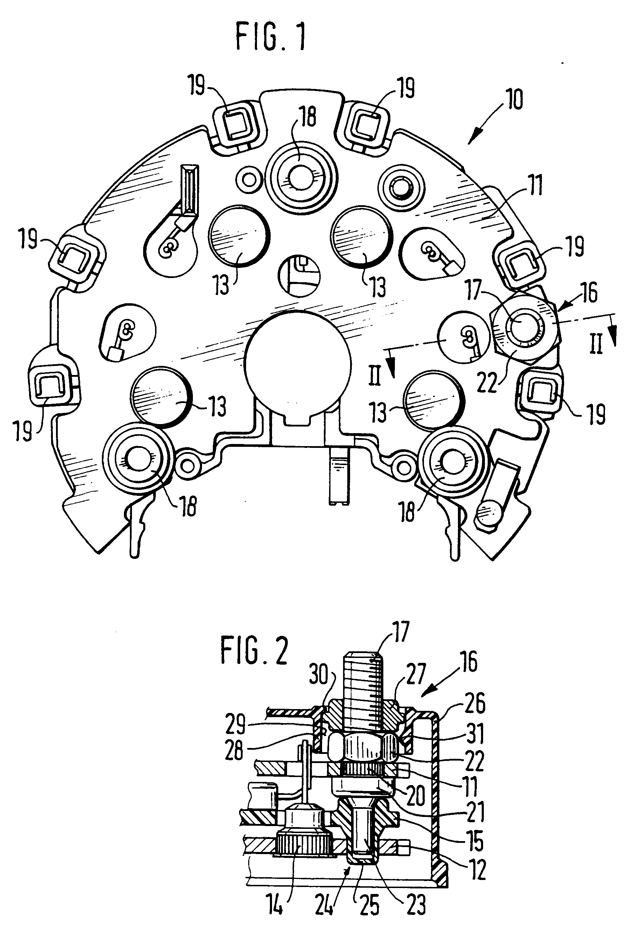

Ein Ausführungsbeispiel der Erfindung ist in der Zeichnung dargestellt und in der nachfolgenden Beschreibung näher erläutert. Es zeigen Figur 1 die erfindungsgemäße Gleichrichtereinrichtung eines Drehstrom-Generators in der Ansicht von vorn und Figur 2 einen Querschnitt durch diese Einrichtung nach der Linie II - II aus Figur 1.

### Beschreibung des Ausführungsbeispieles

Der Aufbau der mit 10 bezeichneten, erfindungsgemäßen Gleichrichtereinrichtung besteht in an sich bekannter Weise (siehe G 87 11 178) aus einer sandwichartigen Anordnung zweier metallischer Kühlplatten 11, 12, die mit Abstand zueinander parallel verlaufen. In der äußeren, in Figur 1 erkennbaren Plus-Kühlplatte 11 sind mehrere Plus-Dioden 13 eingesetzt, wogegen in der hinteren Minus-Kühlplatte 12 Minus-Dioden 14 eingesetzt sind, von denen in Figur 2 lediglich eine erkennbar ist. Ferner ist zwischen den beiden Kühlplatten 11, 12 eine Leiterplatte 15 aus Isolierstoff befestigt, in der nicht erkennbar Leiter zur Verschaltung der Dioden 13, 14 untereinander und mit nicht dargestellten Anschlußdrähten der Ständerwicklung des jeweiligen Drehstromgenerators eingebettet sind. Die vordere Plus-Kühlplatte 11 ist außerdem mit einem Plus-Anschluß 16 versehen, der aus einem Gewindebolzen 17 besteht, an dem ein nichtdargestelltes Batterieanschlußkabel eines Fahrzeugs im montierten Zustand des Drehstromgenerators angeschlossen wird. Mit drei Hohlnieten 18 sind die beiden Kühlplatten 11 und 12 und die dazwischenliegende Leiterplatte 15 miteinander elektrisch isoliert fest verbunden und die Gleichrichtereinrichtung 10 wird durch drei durch diese Hohlnieten 18 hindurchgeführte Schrauben an einem Lagerschild des Drehstrom-Generators festgeschraubt. Durch mehrere außenliegende Quetschverbinder 19 in der Leiterplatte 15 werden die Dioden 13 und 14 nach der Montage der Gleichrichtereinrichtung 10 am Drehstromgenerator mit den Anschlußdrähten seiner Ständerwicklung elektrisch verbunden.

Der aus Figur 2 im Querschnitt erkennbare Plus-Anschluß 16 ist mit der Plus-Kühlplatte 11 elektrisch leitend verbunden, indem sein Gewindebolzen 17 mit einer Rändelung 20 in ein entsprechendes Loch der Kühlplatte 11 eingepreßt ist. Mit einer hinter der Rändelung 20 liegenden Ringschulter 21 liegt der Gewindebolzen 17 an der Rückseite der Kühlplatte 11 an. Mit einer Mutter 22 ist er zusätzlich an der Kühlplatte 11 festgeschraubt. Mit einem hinter der Ringschulter 21 angeformten axialen Zapfen 23 ragt der Gewindebolzen 17 in eine Öffnung 24, vorzugsweise in ein Loch der hinteren Kühlplatte 12. Da diese Kühlplatte 12 auf Minus-Potential liegt, ist der Zapfen 23 in einer Isolierstoffbuchse 25 aufgenommen, die in die Öffnung 24 eingesetzt ist. Die Isolierstoffbuchse 25 ist dabei an den äußeren Bereich der Leiterplatte 15 angeformt, die zwischen der Plus-Kühlplatte 11 und der Minus-Kühlplatte 12 eingeklemmt ist.

Die Gleichrichtereinrichtung 10 ist nach außen durch eine topfförmige Schutzkappe 26 abgedeckt, die in ihrem Boden Lüftungsschlitze sowie Öffnungen für die Anschlüsse der Gleichrichtereinrichtung aufweist. Um am Plus-Anschluß 16 beim Festschrauben bzw. Abschrauben eines Kabels Drehmomentbelastungen von der Rändelung 20 des Gewindebolzens 17 möglichst fern zu halten, ragt das vordere Ende des Gewindebolzens 17 durch eine Metallbuchse 27 hindurch, die in einer Öffnung der Schutzkappe 26 schwimmend und verdrehsicher gelagert ist. Zu diesem Zweck ist an der Öffnung der Schutzkappe 26 ein Kragen 28 angeformt, der an der Innenseite eine Sechseck-Aufnahme 29 aufweist, in die die Metallbuchse 27 mit einer Sechseck-Außenkontur axial geführt und gegen Verdrehen gesichert ist. Um die Metallbuchse 27 gegen ein Herausfallen aus der Sechseck-Aufnahme 29 der Schutzkappe 26 zu sichern, sind am vorderen Ende der Sechseck-Aufnahme 29 drei am Umfang gleichmäßig verteilte radial gerichtete Vorsprünge 30 an der Schutzkappe 26 angeformt und im hinteren Bereich der Sechseck-Aufnahme 29 sind weitere drei radial nach innen gerichtete Vorsprünge 31 vorgesehen. Von den Vorsprüngen 30 und 31 ist in Figur 2 jeweils nur ein Vorsprung 30 und 31 erkennbar.

Da die Gleichrichtereinrichtung 10 nach dem Einbau des Generators im Fahrzeug üblicherweise senkrecht steht, werden bei Schüttelbeanspruchungen die am Plus-Anschluß 16 auftretenden Kräfte über die Rändelung 20 einerseits in die Plus-Kühlplatte 11 und über den Zapfen 23 und die Isolierstoffbuchse 25 in die Minus-Kühlplatte 12 eingeleitet. Ebenso werden Biegekräfte am Gewindebolzen beim Anschließen oder Entfernen eines Anschlußkabels über den Zapfen 23 im wesentlichen von der hinteren Kühlplatte 12 parallel zur Kühlplattenebene aufgenommen und damit ein Verbiegen der vorderen Kühlplatte 11 zuverlässig vermieden. Die schwimmende Metallbuchse 27 in der Schutzkappe 26 verhindert außerdem selbst bei angerostetem Anschluß, daß das Drehmoment beim Lösen des Anschlußkabels auf die untere Mutter 22 übertragen wird, da die Metallbuchse 27 diese Kräfte über ihre Außenkontur auf die Sechseck-Aufnahme 29 der Schutzkappe 26 überträgt. Ein Lösen des Gewindebolzens 17 wird dadurch zuverlässig vermieden.

## Patentansprüche

1. Gleichrichtereinrichtung (10) für Drehstromgeneratoren von Fahrzeugen mit zwei metallischen, zueinander parallel angeordneten Kühlplatten (11, 12), in denen jeweils Plus- (13) bzw. Minus-Dioden (14) mit ihrem Gehäuse eingesetzt sind, mit einer zwischen den Kühlplatten angeordneten Leiterplatte (15) aus Isolierstoff, in der Leiter zur Verschaltung der Dioden untereinander und mit Anschlußdrähten einer Ständerwicklung des Drehstromgenerators eingebettet sind und mit einem Plus-Anschluß (16) an der vorderen der beiden Kühlplatten, der aus einem Gewindebolzen (17) besteht, welcher mit einer Rändelung (20) in einem Loch der vorderen Kühlplatte eingepreßt ist, mit einer dahinter befindlichen Ringschulter (21) an der Rückseite der Plus-Kühlplatte (11) anliegt und vorn mit einer Mutter (22) an der Plus-Kühlplatte (11) festgeschraubt ist, dadurch gekennzeichnet, daß der Gewindebolzen (17) des Plus-Anschlusses (16) mit einem hinter der Ringschulter (21) angeformten axialen Zapfen (23) bis in eine Öffnung (24) der hinteren Minus-Kühlplatte (12) ragt und dort von einer Isolierstoffbuchse (25) aufgenommen ist.

2. Gleichrichtereinrichtung nach Anspruch 1, dadurch gekennzeichnet, daß die Isolierstoffbuchse (25) an der Leiterplatte (15) zwischen den beiden Kühlplatten (11, 12) angeformt ist.

3. Gleichrichtereinrichtung nach Anspruch 1 oder 2, dadurch gekennzeichnet, daß der Gewindebolzen (17) durch eine Metallbuchse (27) hindurchragt, die in einer als Kragen ausgebildeten Öffnung (28) einer Schutzkappe (26) aus Isolierstoff schwimmend und verdrehsicher gelagert ist.

4. Gleichrichtereinrichtung nach Anspruch 3, dadurch gekennzeichnet, daß die Metallbuchse (27) mit einer Sechseck-Außenkontur versehen ist, die in einer Sechseck-Aufnahme (29) am Kragen (28) der Schutzkappe (26) axial geführt ist.

5. Gleichrichtereinrichtung nach Anspruch 4, dadurch gekennzeichnet, daß die Metallbuchse (27) gegen ein Herausfallen aus der Sechseck-Aufnahme (29) der Schutzkappe (26) durch mehrere radial nach innen gerichtete Vorsprünge (30, 31) gesichert ist, die jeweils an den Endbereichen der Sechseck-Aufnahme (29) angeformt sind.

## Claims

1. Rectifier (10) for three-phase current generators in vehicles, having two metallic cooling plates (11, 12) which are arranged parallel to one another and in which in each case positive (13) and negative diodes (14) are inserted with their housings, having a printed circuit board (15) which is arranged between the cooling plates and made of insulating material and in which conductors for connecting the diodes to one another and to connection wires of a stator winding of the three-phase generator are embedded, and having a positive terminal (16) at the front cooling plate of the two cooling plates, which positive terminal (16) consists of a threaded bolt (17) which is pressed with a knurl (20) into a hole of the front cooling plate, rests with an annular shoulder (21), located behind it, on the rear of the positive cooling plate (11) and is screwed tight at the front to the positive cooling plate (11) by a nut (22), characterized in that the threaded bolt (17) of the positive terminal (16) protrudes with an axial pin (23), formed on behind the annular shoulder (21), into an opening (24) of the rear negative cooling plate (12) and is received there by an insulating material bushing (25).

2. Rectifier according to Claim 1, characterized in that the insulating material bushing (25) is formed onto the printed circuit board (15) between the two cooling plates (11, 12).

3. Rectifier according to Claim 1 or 2, characterized in that the threaded bolt (17) protrudes through a metal bushing (27) which is mounted in a floating fashion and secured against rotation in an opening (28), constructed as a collar, of a protective cap (26) made of insulating material.

4. Rectifier according to Claim 3, characterized in that the metal bushing (27) is provided with a hexagonal outer contour which is axially guided in a hexagonal receptacle (29) on the collar (28) of the protective cap (26).

5. Rectifier according to Claim 4, characterized in that the metal bushing (27) is secured against dropping out of the hexagonal receptacle (29) of the protective cap (26) by a plurality of projections (30, 31) which are directed radially inwards and are each formed onto the end regions of the hexagonal receptacle (29).

## Revendications

1. Redresseur (10) pour des générateurs à courant triphasé de véhicules avec deux plaques métalliques de refroidissement (11, 12) disposées en parallèle l'une à l'autre, dans lesquelles sont montées respectivement des diodes Plus (13) ou des diodes Moins (14) avec leur boîtier ; avec une carte à circuit imprimé (15) en matière isolante , dans laquelle sont noyés des conducteurs servant à relier entre elles les diodes et avec des fils de raccordement d'un enroulement de stator de l'alternateur à courant triphasé et avec un raccord Plus (16) sur la partie antérieure des deux plaques de refroidissement, qui consiste en une tige filetée (17) qui est enfoncée par pressage par un moletage (20) dans un trou de la plaque antérieure de refroidissement avec un épaulement annulaire (21) se trouvant derrière sur la face arrière de la plaque Plus de refroidissement (11) et en avant avec un écrou (22) qui est vissé sur la plaque Plus de refroidissement (11), dispositif du redresseur caractérisé en ce que la tige filetée (17) du raccord Plus (16) pénètre par un téton axial (23) formé derrière l'épaulement annulaire (21) jusque dans une ouverture (24) de la plaque Moins de refroidissement postérieure (12) et est logée à cet endroit dans une douille en matière isolante (25).

2. Redresseur selon la revendication 1, caractérisé en ce que la douille en matière isolante (25) est formée sur la carte à circuit imprimé (15) entre les deux plaques de refroidissement (11, 12).

3. Redresseur selon la revendication 1 ou 2, caractérisé en ce que la tige filetée (17) passe à travers une douille métallique (27), qui est montée dans une ouverture (28) ayant la forme d'une collerette, d'un chapeau de protection (26) en matière isolante, de façon flottante et sans pouvoir tourner.

4. Redresseur selon la revendication 3, caractérisé en ce que la douille métallique (27) est pourvue d'un contour extérieur hexagonal, qui passe dans un logement hexagonal (29) de façon axiale sur le col (28) du chapeau de protection (26).

5. Redresseur selon la revendication 4, caractérisé en ce que la douille métallique (27) est empêchée de sortir du logement hexagonal (29) du chapeau de protection (26) par plusieurs saillies, dirigées radialement vers l'intérieur (30, 31), qui sont respectivement formées sur les zones terminales du logement hexagonal (29).
